Europäisches Patentamt

European Patent Office

Office européen des brevets

(11) Publication number: **0 144 866**
**B1**

(12) EUROPEAN PATENT SPECIFICATION

(45) Date of publication of patent specification: **07.09.88**

(21) Application number: **84114132.8**

(22) Date of filing: **22.11.84**

(51) Int. Cl.⁴: **H 01 L 23/14, H 01 L 23/36**

(54) Semiconductor device comprising a substrate.

(30) Priority: **25.11.83 JP 221564/83**

(43) Date of publication of application:
**19.06.85 Bulletin 85/25**

(45) Publication of the grant of the patent:
**07.09.88 Bulletin 88/36**

(84) Designated Contracting States:
**DE FR GB**

(56) References cited:
**EP-A-0 069 901**
**FR-A-2 381 388**
**US-E- 29 325**

**PROCEEDINGS OF THE IEEE 1980 NATIONAL
AEROSPACE AND ELECTRONICS
CONFERENCE, 20th-22nd May 1980, vol. 2,
pages 598-605, IEEE, New York, US; J.W.
BUTLER et al.: "Dual SCR power module"**

(73) Proprietor: **KABUSHIKI KAISHA TOSHIBA
72, Horikawa-cho Saiwai-ku
Kawasaki-shi Kanagawa-ken 210 (JP)**

(72) Inventor: **Tani, Keizo c/o Patent Division
Kabushiki Kaisha Toshiba 1-1 Shibaura 1-chome
Minato-ku Tokyo 105 (JP)**
Inventor: **Saito, Yasumasa c/o Patent Division
Kabushiki Kaisha Toshiba 1-1 Shibaura 1-chome
Minato-ku Tokyo 105 (JP)**

(74) Representative: **Lehn, Werner, Dipl.-Ing. et al
Hoffmann, Eitle & Partner Patentanwälte
Arabellastrasse 4
D-8000 München 81 (DE)**

## Description

This invention relates to a semiconductor device comprising a substrate of a heat conductive and nonmetallic refractory plate having first and second opposed surfaces; first copper or copper alloy sheet bonded on the first surface of the substrate; a second copper or copper alloy sheet bonded on the second surface of the substrate; a semiconductor chip mounted on the first sheet; and a base plate of copper or copper alloy having a thermal expansion coefficient between $16 \times 10^{-6}$ and $22 \times 10^{-6}$ and having a first surface elongate in a longitudinal direction and soldered to the second sheet to act as a heat sink.

Such a device is known from US—A—29 325.

Another conventional semiconductor device provided with an electrically insulated heat sink plate comprises a Cu direct bond (hereafter referred to as "a C.D.B. substrate"), which is constructed by bonding a sheet of copper or copper alloy directly to both planes of a nonmetallic refractory plate prepared from, for example, ceramic material. With the above-mentioned conventional semiconductor device, a semiconductor chip is bonded to one plane of the C.D.B. substrate, and a copper base plate concurrently acting as a heat sink plate is, for example, soldered to the opposite plane of said C.D.B. substrate. In this case, the semiconductor chip and copper base plate are electrically insulated from each other. The copper base plate is hermetically sealed by coating a silicone resin adhesive on the surroundings of the copper base plate and further tightly attaching a case to the surface of said copper base plate by means of said adhesive. Silicone gel is poured into the case to protect the semiconductor chip and an aluminium wire connecting said semiconductor chip to an electrode terminal. After the curing of said silicon gel, epoxy resin is poured and cured to finish the subject semiconductor device.

The copper sheet bonded to both planes of said C.D.B. substrate indicates a substantially equal thermal expansion coefficient to that of the ceramic plate during the manufacture of said C.D.B. substrate, thereby ensuring extremely strong bonding between the ceramic plate and copper sheet. Consequently, the C.D.B. substrate and copper sheet bonded thereto may be regarded as an integral body. Now, let it be assumed that the C.D.B. substrate and copper base plate acting as a heat sink plate are, for example, soldered together. The copper has a thermal expansion coefficient ($\alpha = 17 \times 10^{-6}/°C$), and the ceramic material has a thermal expansion coefficient ($\alpha = 7.7 \times 10^{-6}/°C$). Even if, therefore, both materials can be bonded together in the flat form at the melting point (about 185°C) of solder, the difference between the above-mentioned thermal expansion coefficients causes the bonded mass, when cooled to the normal temperature of 25°C, to indicate at the center such a warped shaped as protrudes toward the ceramic side due to the bimetal effect.

Now let it be assumed that the copper base plate measures 85 mm×30 mm×3 mm and the C.D.B. substrate measures 65 mm×26 mm and is constructed by bonding a copper sheet having a thickness of 0.3 mm to both planes of a cermaic plate having a thickness of 0.6 mm. In this case, the above-mentioned warping reaches as large a level as 200 to 250 microns. When, therefore, the bonded mass warped to the above-mentioned extent is set in place by screwing both end portions of the copper base plate, a gap measuring more than 200 microns appears between said copper base plate and the member used on the subject semiconductor device-fixing side. As a result, a heat releasing effect is noticeably obstructed. Further, if it is attempted to eliminate such warping by forcefully applying a stress, then difficulties will arise such as the breakage of the semiconductor chip or the cracking of the ceramic component of the C.D.B. substrate, thereby rendering the subject semiconductor device unadapted for use.

Further when the copper base plate is warped, a gap appears in the opening of the case when it is adhered to the copper base plate, thus making it necessary to apply a large amount of silicon adhesive to fill up said gap, and consequently presenting considerable difficulties in assembling a semiconductor device. Moreover, such a semiconductor device is accompanied with the drawbacks that adhesion between the case and copper base plate is weak, the hermetical sealing of the interstice between the case and copper base plate is ready to break, and a semiconductor device held in said interstice is reduced in its moisture proof property.

It is accordingly the object of this invention to provide a semiconductor device free from warping by applying a copper base plate having such a thickness as can absorb stresses resulting from the bimetal effect of the C.D.B. substrate and copper base plate.

Another aspect of this invention is to provide a highly reliable semiconductor device, wherein the warping of a copper base plate concurrently acting as a heat sink plate can be reduced to a practically negligible extent, and the loss of a heat sink effect and the cracking of a semiconductor device can be prevented.

According to the invention, the semiconductor device defined in the first paragraph of this specification is characterised in that said first and second sheets are directly bonded on the first and second surfaces of the substrate, respectively; and said base plate has a thickness at least 35 times the thermal expansion in the longitudinal direction of the base plate at the soldering temperature.

This invention can provide a semiconductor device wherein the copper base plate bonded to the C.D.B. substrate is allowed to have a thickness at least over 35 times the extent to which the copper base plate is extended when thermally bonded to said C.D.B. substrate.

This invention can be more fully understood from the following detailed description when taken in conjunction with the accompanying drawings, in which:

2

Fig. 1 is a partial lateral sectional view of a semiconductor device embodying this invention;

Fig. 2 is an enlarged sectional view of the bonded sections of the C.D.B. substrate and copper base plate; and

Fig. 3 graphically shows the relationship between the length and the extent of warping of the copper base plate used with the semiconductor device of Fig. 1.

A description may now be made with reference to the accompanying drawings of a semiconductor device embodying this invention.

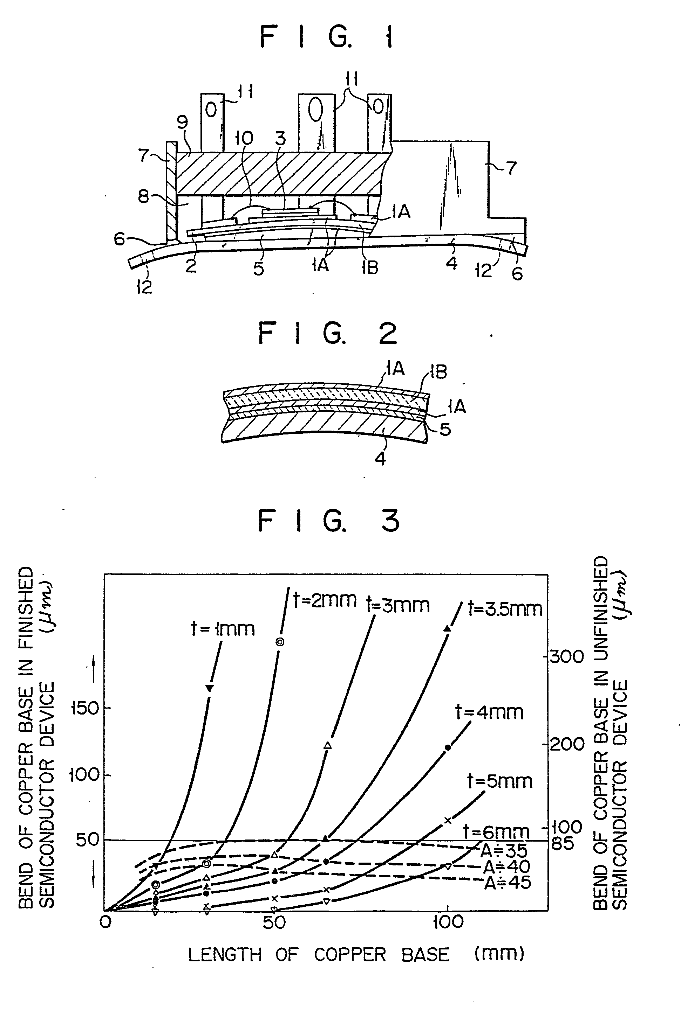

Fig. 1 is a partial lateral sectional view of said semiconductor device. The subject semiconductor device is manufactured by the following steps. First, a C.D.B. substrate 2 is provided which is constructed by directly bonding a sheet 1A of, for example, copper or copper alloy to both planes of a nonmetallic refractory plate 1B. A semiconductor chip 3 is bonded to one plane of said C.D.B. substrate 2. A copper base plate 4, concurrently acting as a heat sink plate, is adhered to the opposite plane of said C.D.B. substrate 2 by means of, for example, solder 5. A silicone adhesive 6 is coated on the periphery of the copper base plate 4, thereby adhering the peripheral portion of the opening of a case 7 to that of the copper base plate 4. Silicone gel 8 is poured into the case 7. After the silicone gel 8 is cured, epoxy resin 9 is also poured into the case 7. After the cure of said epoxy resin 9, the whole mass is cast into a prescribed form. The contact portion of the semiconductor chip 3 is connected to electrode terminals 11 by means of an aluminium wire 10. Said copper base plate 4 had screw holes 12 at both the end portion.

The fact that the copper base plate 4 used with the semiconductor device shown in Fig. 1 is warped is assumed to result from the bimetal effect of the C.D.B. substrate 2 and said copper base plate 4. Various materials were used to make experiments with respect to the thickness and shape of the C.D.B. substrate 2 and the composition, shape and thickness of said copper base plate 4. It was experimentally confirmed that a semiconductor device could be produced wherein the heat-releasing effect was little lost and the warp of the copper base plate could be reduced to a practically negligible extent.

A description may now be made of the experiments which eventually resulted in the present invention. Throughout the experiments, the direction in which the central portion of the copper base plate 4 protruded toward the ceramic plate 1B was taken as plus +.

(a) Thickness of the ceramic plate 1B

TABLE 1

| Ceramic plate thickness (mm) | Maximum warp (micrometers) | Heat resistance of semiconductor device (°C/W) |
|---|---|---|
| 0.6 | 250 | 0.20~0.24 |
| 1.0 | 100 | 0.30~0.38 |
| 1.5 | 50 | 0.40~0.50 |

The ceramic plate 1B measured 65 mm (length)×26 mm (width), and the copper base plate measured 85 mm×30 mm×3 mm.

Table 1 above shows that an increase in the thickness of the ceramic plate 1B ensures a decline in the warp of the copper base plate 4. However, it was experimentally found that an increase in the ceramic plate 1B raised the heat resistance of the resultant semiconductor device, the heat release at the fitting of a semiconductor device was reduced on the whole, and consequently, the attempt to increase the thickness of the ceramic plate 1B proved objectionable.

(b) Composition of the base plate 4

TABLE 2

| Base material | Maximum warp (micrometers) | Heat resistance of semiconductor device (°C/W) |
|---|---|---|
| Brass | 200 | 0.30~0.35 |
| Iron | 180 | 0.32~0.37 |

The members used in the experiment (b) had the same measurements as those of the experiment (a).

3

**0 144 866**

Table 2 shows that the warp of the base plate still occurred even when the base plate was prepared from brass or iron having a smaller thermal expansion coefficient than copper. The brass and iron having a lower heat conductivity than copper led to an increase in the heat resistance of the semiconductor device. It was found therefore that the application of a base plate prepared from any other material than copper was unsatisfactory.

(c) Shape of copper base plate 4

It was attempted to render the copper base plate extensible or contractible by application of honing or corrugation. Nevertheless, the copper base plate still warped to an extent of 200 to 300 micrometers, showing that said attempt proved quite ineffective. It was further tried to warp the copper base plate crosswise in order to prevent the copper base plate from lengthwise bending and thereby reduce the warp caused by the bimetal effect. Still, the base plate warped to an extent of 170 to 230 micrometers, showing that said process was quite fruitless.

(d) The amount of solder for effecting bonding between the C.D.B. substrate 2 and copper base plate 4

It was tried to apply a large amount of solder for the bonding bewteen the C.D.B. substrate 2 and copper base plate 4 in order to effect the deformation of the solder, thereby, releasing the internal stress of the bonded mass. The application of the solder even to a thickness of 2 mm proved ineffective to reduce on warp of the base plate, which indicated as large as warp as 200 micrometers even at minimum.

(e) Thickness of the copper base plate 4

TABLE 3

| Sample number | C.D.B. Substrate thickness (mm) | Copper plate thickness (mm) | Maximum warp (micrometers) | Heat resistance of a semiconductor device (°C/W) |
|---|---|---|---|---|
| A | 1.2 | 3 | 200~250 | 0.20~0.24 |
| B | 1.2 | 4 | 50~80 | 0.19~0.24 |
| C | 1.2 | 5 | 30~60 | 0.19~0.23 |
| D | 1.2 | 6 | 0~30 | 0.18~0.22 |
| E | 1.2 | 7 | 0 | 0.17~0.22 |

The members provided in the above experiment (e) had the following measurements:

Copper base plate 4    85 mm×30 mm×t (thickness),
Ceramic plate 1B    65 mm×26 mm×0.6 mm, and
Copper sheet 1A    0.3 mm (thickness).

Table 3 above shows that an increase in the thickness of the copper base plate 4 led to a decline in its maximum extent of warping and prevented the semiconductor device from having a large heat resistance. The following is the reason for the occurrence of the above-mentioned advantageous event. When the solder melts at a temperature of about 185°C, the copper base plate 4 (thermal expansion of 177 micrometers) and ceramic substrate 1B (thermal expansion of 80 micrometers) are bonded together. When the bonded mass is cooled to the normal temperature 25°C, an internal stress takes place in the bonded mass to an extent equal to a difference of 97 micrometers between the above-mentioned thermal expansions of 177 micrometers and 80 micrometers. In this case, the internal stress of the bonded mass progressively decreases from the bonded junction of the copper base plate 4 and ceramic substrate 2B to the opposite nonbonded edge of said bonded mass. If, therefore, the copper base plate 4 has a far larger thickness than the above-mentioned difference of 97 microns between the thermal expansion of said copper base plate 4 and ceramic substrate 1B, then no warp appears on the opposite nonadhered side of the copper base plate 4.

The warping amounts of Samples A to E of the copper base plate 4, which appeared up to the finished assembly of the subject semiconductor device, were traced, the results being set forth in Table 4 below. It was found that the contraction stress resulting from the cure of the subsequently poured epoxy resin so acted as to offset the stresses caused by the aforementioned thermal expansion of the copper base plate 4 and ceramic substrate 1B. Therefore, the warping of the copper base plate 4 in the finished semiconductor device was appreciably reduced. The above-mentioned Samples A to E of the copper base plate 4 involved in the finished semiconductor device showed warping as listed in Table 4 below.

4

TABLE 4

| Sample number | Maximum warping (micrometers) |
|---|---|
| A | 130~160 |
| B | −10~40 |
| C | −20~30 |
| D | −30~0 |
| E | −70~−20 |

When a finished semiconductor device is attached to a fixing member, heat-releasing grease is applied to the fitting plane of said semiconductor device. If, therefore, the warping of the copper base plate 4 involved in the finished semiconductor device is less than 50 micrometers, no practical difficulties arise. When attached to the fixing member, the finished semiconductor device is screwed at both end portions. Therefore, the minus warp of the central portion of the copper base plate 4, which advances in a direction away from the ceramic substrate 1B, is forcefully corrected so as to render said central portion substantially flat. Consequently, Samples B to E of the copper base plate 4 whose warping is indicated in Tables 3 and 4 above fall within the range of practical application. If the copper base plate 4 is rendered excessively thick, the cost of the component parts of the subject semiconductor device will be raised. Therefore, a finished semiconductor device involving, for example, Sample B of the copper base plate 4 proves practically satisfactory.

Fig. 3 graphically shows the relationship between the length of the copper base plate (given on the abscissa) and warping (indicated on the ordinate). In one section of Fig. 3, the thickness t (solid line) of the copper base plate is taken as a parameter. In the other section of Fig. 3, a ratio A (broken line) of the thickness t of the copper base plate to the thermal expansion $\Delta l$ of the soldered copper base plate is taken as a parameter.

To minimize the heat resistance of a semiconductor device, therefore, it is advised that, assuming the application of a ceramic substrate 1B has a thickness of 0.5 to 0.6 mm, a copper base plate should be applied which has such a thickness as over 35 times the thermal expansion $\Delta l$ of copper during soldering.

Table 5 below sets forth the length of a copper base plate embodying this invention, the corresponding thickness t, the warping of the resultant semi-finished semiconductor device, and the ratio of the thickness to the thermal expansion $\Delta l$ of said copper base plate.

TABLE 5

| Length l of the copper base plate (mm) | Thickness t of the copper base plate (mm) | Warping of the copper base plate (micrometers) | Ratio of the thickness t to the thermal expansion rate $\Delta l$ of the copper plate (t/$\Delta l$) |
|---|---|---|---|
| 15 | 0.9 | 60~70 | 40 |
| 30 | 1.8 | 65~75 | 40 |
| 50 | 3.0 | 75~85 | 40 |
| 65 | 3.9 | 70~80 | 40 |
| 100 | 5.2 | 65~75 | 35 |

The notation $\Delta l$ given in Table 5 above represents the thermal expansion of the copper base plate 4 when soldered to the C.D.B. substrate 2 (temperature difference: 160°C).

Table 5 above shows the warping of a semi-finished semiconductor device constructed by soldering the copper base plate 4 to the C.D.B. substrate 2. If the warping of said semifinished products falls within the range of up to 85 micrometers, then it is possible to reduce said warping down to about 50 microns and prove practically applicable.

This invention is characterized in that the warping stresses of the copper base plate and C.D.B. substrate, resulting from their bimetal effect, are allowed to act crosswise of the copper base plate, thereby

5

deforming only that plane of the copper base plate which is bonded to the C.D.B. substrate and preventing the semifinished product as a whole from indicating any warp. Consequently, the present invention offers the advantages that the copper base plate can be finished substantially in the flat form. In the subsequent adhering step, the case can be smoothly and tightly adhered to the copper base plate; when a finished product is screwed to the fixing member, its flat fitting plane can be tightly attached to said fixing member, thereby minimizing losses in heat release; a highly reliable semiconductor device can be manufactured without any damage to the internal semiconductor chip and C.D.B. substrate; and it is possible to resolve various difficulties occurring in the conventional semiconductor device-assembling step such as the unsatisfactory adhesion of the case, power waste resulting from noticeable losses in heat release, deterioration of the weather proof property of the semiconductor device, and separation between the case and copper base plate during heating.

The copper base plate involved in the semiconductor device embodying this invention can be prepared from copper or copper alloy whose thermal expansion coefficient ranges between $16\times10^{-6}$ and $22\times10^{-6}$.

**Claims**

1. A semiconductor device comprising:
a substrate (2) of a heat conductive and nonmetallic refractory plate having first and second opposed surfaces;
a first copper or copper alloy sheet (1A) bonded on the first surface of the substrate (2);
a second copper or copper alloy sheet (1A) bonded on the second surface of the substrate (2);
a semiconductor chip (3) mounted on the first sheet (1A); and
a base plate (4) of copper or copper alloy having a thermal expansion coefficient between $16\times10^{-6}/°C$ and $22\times10^{-6}/°C$ and having a first surface elongate in a longitudinal direction and soldered to the second sheet (1A) to act as a heat sink; characterised in that
said first and second sheets are directly bonded on the first and second surfaces of the substrate (2), respectively; and
said base plate (4) has a thickness of at least 35 times the thermal expansion in the longitudinal direction of the base plate (4) at the soldering temperature.

2. A semiconductor device according to claim 1 wherein an opening of a case (7) is fitted to the base plate (4) with an epoxy resin (9) set therein.

3. A semiconductor device according to claim 1 or 2 wherein said base plate (4) is provided with a screw hole (12) at both end portions to effect fitting of said base plate to a fixing member.

4. A semiconductor device according to any one of the preceding claims wherein said substrate (2) has a thickness of 0.5 to 0.6 mm.

5. A semiconductor device according to any one of the preceding claims wherein the substrate (2) is of ceramic.

6. A semiconductor device according to claim 5 wherein said ceramic has a coefficient of expansion of $7.7\times10^{-6}/°C$.

7. A semiconductor device according to any one of claims 1 to 6 wherein the solder employed to bond the base plate (4) to the second sheet (1A) has a melting point of about 185°C.

8. A semiconductor device according to any one of the preceding claims wherein said substrate (2) is rectangular.

9. A semiconductor device according to any one of the preceding claims wherein said base plate (4) is rectangular.

**Patentansprüche**

1. Halbleitervorrichtung mit:
einem Substrat (2) aus einer wärmeleitenden und nicht metallischen feuerfesten Platte mit ersten und zweiten gegenüberliegenden Oberflächen;
einer ersten Kupfer- oder Kupferlegierungsschicht (1A), die auf die erste Oberfläche des Substrats (2) aufgetragen ist;
einer zweiten Kupfer- oder Kupferlegierungsschicht (1A), die die zweite Oberfläche des Substrats (2) aufgetragen ist;
einem Halbleiterchip (3), der auf der ersten Schicht (1A) befestigt ist; und
einer Grundplatte (4) aus Kupfer oder einer Kupferlegierung, die einen thermischen Ausdehnungs-koeffizienten zwischen $16\times10^{-6}/°C$ und $22\times10^{-6}/°C$ aufweist, und die eine erste Oberfläche besitzt, die sich in Längsrichtung erstreckt und die an die zweite Schicht (1A) gelötet ist, um als Wärmesenke zu dienen, dadurch gekennzeichnet, daß
die erste und die zweite Schicht unmittelbar auf der ersten bzw. zweiten Oberfläche des Substrats (2) verbunden aufgebracht sind, und
die Grundplatte (4) eine Dicke von zumindest dem 35fachen der thermischen Ausdehnung in Längsrichtung der Grundplatte (4) bei der Löttemperatur besitzt.

2. Halbleitervorrichtung nach Anspruch 1, dadurch gekennzeichnet, daß eine Öffnung eines Gehäuses (7) auf die Grundplatte (4) mit einem darin eingesetzten Epoxydharz (9) aufgesetzt ist.

3. Halbleitervorrichtung nach Anspruch 1 oder 2, dadurch gekennzeichnet, daß die Grundplatte (4) mit einer Schraubenbohrung (12) an beiden Endbereichen ausgestattet ist, um eine Montage der Grundplatte an einem Befestigungselement zu ermöglichen.

4. Halbleitervorrichtung nach einem der vorhergehenden Ansprüche, dadurch gekennzeichnet, daß das Substrat (2) eine Dicke von 0,5 bis 0,6 mm aufweist.

5. Halbleitervorrichtung nach einem der vorhergehenden Ansprüche, dadurch gekennzeichnet, daß das Substrat (2) eine Keramik ist.

6. Halbleitervorrichtung nach Anspruch 5, dadurch gekennzeichnet, daß die Keramik einen Ausdehnungskoeffizienten von $7,7 \times 10^{-6}/°C$ besitzt.

7. Halbleitervorrichtung nach einem der Ansprüche 1 bis 6, dadurch gekennzeichnet, daß das Lötmittel, das verwendet wird, um die Grundplatte (4) mit der zweiten Schicht (1A) zu verbinden, einen Schmelzpunkt von ungefähr 185°C besitzt.

8. Halbleitervorrichtung nach einem der vorhergehenden Ansprüche, dadurch gekennzeichnet, daß das Substrat (2) rechteckig ist.

9. Halbleitervorrichtung nach einem der vorhergehenden Ansprüche, dadurch gekennzeichnet, daß die Grundplatte (4) rechteckig ist.

## Revendications

1. Un dispositif semi-conducteur comprenant:
un substrat (2) constitué par une plaque réfractaire non métallique conductrice thermique ayant une première surface et une seconde surface opposées l'une à l'autre;
une première tôle en cuivre ou en alliage de cuivre (1A) liée à la première surface du substrat (2);
une seconde tôle en cuivre ou en alliage de cuivre (1A) liée à la seconde surface du substrat (2);
une puce à semi-conducteurs (3) montée sur la première tôle (1A); et
une plaque de base (4) en cuivre ou en alliage de cuivre ayant un coefficient de dilatation thermique compris entre $16 \times 10^{-6}/°C$ et $22 \times 10^{-6}/°C$ et ayant une première surface allongée dans la direction longitudinale et soudée à la seconde tôle (1A) pour agir comme un dissipateur thermique, caractérisé en ce que la première et la seconde tôle sont liées directement à la première et à la seconde surface du substrat (2) respectivement; et que
ladite plaque de base (4) a une épaisseur d'au moins 35 fois la dilatation thermique dans la direction longitudinale de la plaque de base (4) à la température de soudure.

2. Un dispositif semi-conducteur selon la revendication 1, selon lequel une ouverture d'un boîtier (7) est ajustée à la plaque de base (4) au moyen d'une résine époxy (9) placée là-dedans.

3. Un dispositif semi-conducteur selon la revendication 1 ou 2, selon lequel la plaque de base (4) est munie d'un trou de vis (12) à ses deux portions d'extrémité pour l'ajustage de ladite plaque de base à un élément de fixation.

4. Un dispositif semi-conducteur selon l'une quelconque des revendications précédentes, selon lequel le substrat (2) a une épaisseur de 0,5 à 0,6 mm.

5. Un dispositif semi-conducteur selon l'une quelconque des revendications précédentes, selon lequel le substrat (2) est en céramique.

6. Un dispositif semi-conducteur selon la revendication 5, selon lequel ladite céramique a un coefficient de dilatation de $7,7 \times 10^{-6}/°C$.

7. Un dispositif semi-conducteur selon l'une quelconque des revendications 1 à 6, selon lequel la soudure employée pour lier la plaque de base (4) à la seconde tôle (1A) a un point de fusion d'environ 185°C.

8. Un dispositif semi-conducteur selon l'une quelconque des revendications précédentes, selon lequel ledit substrat (2) est rectangulaire.

9. Un dispositif semi-conducteur selon l'une quelconque des revendications précédentes, selon lequel ladite plaque de base (4) est rectangulaire.

F I G. 1

F I G. 2

F I G. 3

BEND OF COPPER BASE IN FINISHED SEMICONDUCTOR DEVICE ($\mu m$)

BEND OF COPPER BASE IN UNFINISHED SEMICONDUCTOR DEVICE ($\mu m$)

t=1mm  t=2mm  t=3mm  t=3.5mm

t=4mm

t=5mm

t=6mm

A≒35
A≒40
A≒45

150

100

50

300

200

100
85

0        50        100

LENGTH OF COPPER BASE (mm)